(19) Europäisches Patentamt / European Patent Office / Office européen des brevets

(11) **EP 4 307 048 A1**

(12) **EUROPEAN PATENT APPLICATION**

(43) Date of publication:
**17.01.2024   Bulletin 2024/03**

(21) Application number: **22184125.7**

(22) Date of filing: **11.07.2022**

(51) International Patent Classification (IPC):
**G03F 7/00** *(2006.01)*      **B81C 1/00** *(2006.01)*

(52) Cooperative Patent Classification (CPC):
**G03F 7/0002; B81C 1/0046**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Morphotonics Holding B.V.**
**5503 LM  Veldhoven (NL)**

(72) Inventors:
• **TER MEULEN, Jan Matthijs**
  **5644 NR EINDHOVEN (NL)**
• **DEKKER, Tim**
  **5658 RD Eindhoven (NL)**
• **NEELEN, Rob Antonius Waltherus**
  **5643 HN Eindhoven (NL)**

(74) Representative: **Patentwerk B.V.**
  **P.O. Box 1514**
  **5200 BN 's-Hertogenbosch (NL)**

(54) **ELECTRICAL FLEXIBLE STAMP**

(57)    The invention pertains to a flexible stamp (1) for imprinting, texturing or transferring roll-to-roll and roll-to-plate processes comprising a flexible sheet of material, an electrically conductive material (5), at least two electrical contacts (4) and a three-dimensional texture (2) on at least one surface.

The application further pertains to an imprinting, texturing, transferring or embossing system for a roll-to-plate process comprising at least one roller and at least one flexible stamp which flexible stamp has an electrically conductive connection to the apparatus and wherein the system comprises at least a means to steer the flexible stamp electrically.

**Fig. 1**

## Description

The invention pertains to a stamp for texturing, patterning or transferring processes in a wafer-scale or plate-to-plate, roll-to-roll, roll-to-plate and plate-to-roll imprint process.

Wafer-scale, roll-to-plate and plate-to-roll and roll-to-roll processes are used for imprinting or texturing rigid or flexible substrates or to transfer materials or even small devices such as micro-LEDs to rigid or flexible substrates. Exact positioning is essential in all these fields.

Currently in wafer-scale, roll-to-plate, plate-to-roll and roll-to-roll processes, the stamp is a passive working tool which only serves as a mold for the texture or the materials or items it is to transfer. Especially, it is not possible to react on individual process parameters such as individual pressure anomalies or randomly occurring gas bubbles underneath the flexible stamp during processing.

It is the object of the invention to solve this problem.

The problem is solved by a stamp for imprinting, texturing or transferring roll-to-roll, plate-to-roll and roll-to-plate processes comprising a sheet of material as a carrier, at least one surface, an electrically conductive material, at least two electrical contacts

A stamp according to the application is a device that is able to transfer a pattern, a texture or material onto an external surface with the ways of transfer not being particularly limited.

The stamp may comprise comprises a pattern which might be a three-dimensionally textured surface comprising openings and elevations. The textured surface may either be a negative or a positive image of a texture to be textured, patterned or transferred onto a target surface. A positive image of a texture is an image where an elevation on the stamp is transferred into an elevation on the target surface and an opening on the stamp is transferred into an opening on the target surface. A negative image is an image where an elevation on the stamp is transferred into an opening on the target surface and where an opening on the stamp is transferred into an elevation on the target surface.

The stamp according to the application may e.g. transfer ink or coating material onto a surface and thus produce an imprinting pattern on an external surface similar to the working principle of an office stamp. In this mode of operation, the elevations of the stamp are wetted with ink or coating material and then pressed on the target surface in such a manner that on the target surface, the parts of the stamp that have been wetted with ink or coating material become visible. Said principle is known as relief imprinting. The stamp may also be brought in contact with a liquid, molten or viscous material either on the stamp itself or on a surface in such a way that said liquid, molten or viscous material adapts to the texture of the stamp and is hardened e.g. by heating, cooling or by electromagnetic radiation while being in contact with the stamp. Upon removal of the stamp, the negative image of the stamp is then formed in the hardened material which is thus textured like a spot of molten wax on a document by a traditional seal matrix. This imprinting principle is known as intaglio imprinting.

The stamp according to the application may also be used to transfer small, solid objects such as micro-LEDs from an initial surface to a target surface.

No matter whether the stamp is used for imprinting, embossing or transferring, the stamp may have a so-called active area which is the area which is suitable for carrying out the processes the stamp is used for and is thus functionalized accordingly. The active area may differ from the rest of the stamp. In case the stamp is for imprinting and/or embossing purposes, the active area may comprise an imprinting or embossing texture. In case the stamp is used for transferring of e.g. material or small, solid objects, the stamp may comprise gripper units which may grip small, solid objects either mechanically, adhesively or by electrical or magnetic fields. A gripper unit working using an electrical field may be a capacitor plate or other means to hold objects. A gripper unit working using a magnetic field may be an inductivity such as an electromagnetic coil. For certain applications, the active area can be a blank area.

Within the context of the present application a carrier can be a sheet of material such as a plate, a panel, a board, a foil, a laminate or a fabric or any other web-like material. Depending on the material and the thickness of the carrier, the carrier may be rigid or flexible. In an embodiment, the carrier determines the mechanical properties of the flexible stamp. If thus the carrier is flexible, then the stamp may also be flexible while if the carrier is rigid, the stamp may also be rigid.

If throughout this application, a "stamp" is mentioned, it may either be a rigid or a flexible stamp unless otherwise stated. Throughout this application, the term "flexible" means that an item has a Young's modulus in range of 0.1 to 200 GPa. The carrier may have a front surface and a rear surface. In an embodiment, the carrier is a foil comprising polyethylene terephthalate, polyethylene naphthalate, polycarbonate, polyimide, thin metal sheet, glass or any combination thereof. In an embodiment, the carrier may be a laminate of several foils of the same or different polymeric materials or of a plastic foil and thin glass panels or thin metal sheets. The carrier material may be transparent for visible and/or UV radiation. In an embodiment, the stamp has a thickness of not more than 500 $\mu$m. In an embodiment, the stamp is bendable to a radius of less than 50 cm or less than 20 cm. Said bendability also holds for the electrical contacts.

In an embodiment, the stamp may be mounted to a device using any suitable means known to the person skilled in the art. The stamp may e.g. be mounted on one or more belts which belts may be movable. The stamp may furthermore also be mounted to a holder or a chuck such as a moving chuck.

The stamp according to the present application may furthermore be movable, partly movable or completely fixed. In an embodiment, the stamp is movable parallel to the moving direction of the goods which are imprinted, textured, embossed or on which material is transferred by the stamp.

In an embodiment, the stamp is movable only perpendicular to the moving direction of the goods which are imprinted, textured, embossed or on which material is transferred by the stamp.

In an embodiment, the stamp is not movable at all and the goods which are imprinted, textured, embossed or on which material is transferred by the stamp are pressed against the stamp.

An electrically conductive material according to the application is any material that does not change its chemical composition while conducting electric energy and which shows an electrical resistivity of $100 \frac{\Omega mm^2}{m}$ or less. The electrically conductive material may thus be a metal such as iron, aluminum, copper, silver, gold, tin or any alloy thereof. The electrically conductive material may further be any non-metallic inorganic compound or element such as graphite, graphene, carbon nanotubes, carbon fibers or niobium oxide. The electrically conductive material may furthermore be an electrically conductive polymer such as polyacetylene, poly-3,4-ethylendioxythiophen, polypyrrol or any other electrically conductive polymer known to the person skilled in the art.

In an embodiment, the electrically conductive material may be essentially transparent for visible and/or ultraviolet light such as doped metal oxides such as indium-tin oxide (ITO), antimony-doped tin oxide or aluminum-doped zinc oxide (AZO), indium doped zinc oxide (IZO) or gallium doped zinc oxide (GZO). Transparent electrically conductive materials may especially be used in case light is used for curing and/or detection purposes in an imprinting, embossing or transferring process using a stamp according to the application. In an embodiment, a transparent electrically conductive material may be combined with thin glass sheets comprised in the stamp for reinforcement purposes.

The electrically conductive material may be comprised in the stamp in the form of conductive paths. Said conductive paths may connect to a functional electric device.

In an embodiment, the electrically conductive material has a negligible influence on the optical properties of the stamp. The optical properties such as transparency and/or reflectivity of a stamp may differ by at most 5% compared to a stamp which differs from the stamp according to the application only by the absence of the electrically conductive material.

In an embodiment, the electrically conductive material is present in the stamp in the form of wires or thin ribbons.

In an embodiment, the flexibility of the electrically conductive material may be the same or higher than the flexibility of the carrier.

The electrical contacts may be applied using a printing method, sputtering, taping, lithography, imprinting or other means.

The electrical contacts may be galvanic, capacitive or inductive. Said contacts may either be suited to connect external devices or power sources thereto or said electrical contacts may be electrically isolated from devices outside the stamp but connected to devices comprised in the stamp such as photovoltaic cells, batteries or electromagnetic coils which may generate electrical power by induction.

In an embodiment, the contacts are in total or in part made of transparent electrically conductive materials. In an embodiment, at least the electrical contacts which are present in the active area of the stamp are made of a transparent electrically conductive material.

In an embodiment, the contacts are of non-transparent electrically conductive materials such as metal. In order to not deteriorate the optical properties such as transparency of the active area of the stamp, the contacts may be arranged around the active area.

In an embodiment, the stamp comprises an internal electrical power source such as a battery like a rechargeable battery, a photovoltaic cell, a capacitor, an electromagnetic coil which may generate electrical power by inductive or capacitive coupling or any combination of said mechanisms. All said devices have to fulfill special requirements concerning flexibility and thickness in order not to deteriorate the operationability of the stamp according to the application. A battery may be a bulk solid state battery or a thin-film solid state battery. A capacitor may be a supercapacitor such as a thin or printed supercapacitor.

In case the stamp may comprise a battery, the stamp may be suited for being mounted and unmounted from an imprinting, embossing or transferring device wherein the stamp is used for changing and/or charging the battery.

In an embodiment, the electrical contacts may be suited to be connected to devices out of the stamp.

In an embodiment, the electrical contacts may be comprised in clamps which clamps allow for mechanical and electrical attachment of the stamp to an imprinting, texturing or transferring apparatus.

In an embodiment, the stamp may comprise a functional electrical component or a sensor. A functional electrical component may either be any component or device which converts electrical energy into a different form of energy and thereby carries out a function such as e.g. heating, light emission, mechanical actuation or force fields or carries out the function to determine changes in current or voltage acting as sensor determining for instance changes in stamp stretch, temperature or pressure.

A functional electrical component for heating may e.g. be an electrical resist heater or a Peltier device which may even be used for electrical heating and cooling. Using an electrical resist heater or a Peltier device, the viscosity of resin underneath the stamp may be influenced or the resin may thermally be cured.

A functional electrical component for light emission may e.g. be a light-emitting diode. In an embodiment, the light emitting diode comprised in the stamp is a thin-film light-emitting diode or a flexible thin-film light emitting diode. Using a functional electrical component for light emission, a resin underneath the stamp may be cured or otherwise hardened, e.g. by cooling, UV radiation, evaporation of a solvent or heating .

A functional electrical component suitable for mechanical action may be an actuator such as a piezo actuator which may either carry out vibrational or translatory movements. Using a functional electrical component suitable for mechanical action, several functionalities may be carried out. Fast vibrational movements may be used to emit gas bubbles from resin underneath the stamp in a similar manner as ultrasound is used for degassing. Furthermore, by movements the rheological properties and thus the viscosity of a resin underneath the stamp may be influenced. Actuators such as piezo actuators may furthermore also be used as grippers comparable to tweezers to grep and to release small pieces of solid material.

A functional electrical element converting electrical energy into a force field may e.g. be a capacitor plate which is embedded into the stamp which then also serves as part of a dielectric material separating the capacitor plate within the stamp from a second capacitor plate or an item serving as second capacitor plate outside the stamp. Upon application of voltage between said two capacitor plates, an electrical field may be formed between the inside and the outside of the stamp which may be used to e.g. electrostatically bind items such as small pieces of solid material to the stamp. Another functional electric device converting electrical energy into a force field may be an inductivity which forms a magnetic field if electricity flows therethrough. Said magnetic field may be used to selectively attract and release items to and from the stamp.

A sensor may convert physical effects such as strain, pressure, temperature or light into an electrical signal which may be amplified for detection. Said functional electrical component and/or sensor may be located in parts or in the whole active area of the stamp and e.g. heat the whole area where it is located or detect the pressure being exerted to the stamp or the strain exerted to the stamp. The stamp according to the present application may comprise one or more sensors.

In an embodiment, the functional electrical component is pixilated which means that not one large functional electric device is comprised in the stamp but that the active area of the stamp or parts thereof are tiled by a plurality of small functional electrical components which selectively may be switched on and off and/or steered and may thus carry out their functions at specific locations.

The pixilated electrical component may e.g. be pixilated heating pads, pixilated gripper arrays, pixilated piezo actuators, pixilated light sources or any combination thereof. Actuators such as piezo actuators may further be used as ultrasonic heaters for lowering the viscosity of resin underneath the stamp.

The sensors may be pixilated and thus, the stamp may comprise pixilated pressure sensors such as load cell arrays, pixilated strain sensors, pixilated temperature sensors or pixilated light sensors or any combination thereof. Said pixilated sensors may allow for specific detection of said physical effects for regions under the stamp.

A pixilated functional electrical component or a pixilated sensor according to the application is a functional electrical component or a sensor which is comprised in the stamp at least twice with the two devices having no spatial overlap and with the two devices being able to be used selectively for the region they are covering. Throughout this application, the term "pixilated" is not to be understood in such a way that the elements of a pixilated device have to form a closed area or are in direct vicinity to each other. Elements of a pixilated device may be distributed over an area with space between different elements which may be a multiple of the size of the elements.

In an embodiment, the stamp may comprise a combination of pixilated sensors and pixilated functional electric components. The skilled person knows that any of the mentioned functional electric components and sensors may be combined with each other.

In an embodiment the sensors might be placed symmetrically at both sides of the active area along the imprint direction.

In an embodiment the sensors might be placed in a row at one or both sides of the active area across the imprint direction also called as the start or stop side of the stamp.

In an embodiment the sensors might be placed in a circle at a round mold.

The stamp may further comprise an electric circuit. In an embodiment, the electric circuit steers the functional electrical components and/or the sensors in the stamp, no matter whether they are pixilated or not. The electric circuit may steer the functional electrical components based on data provided by the sensors.

In an embodiment, the stamp may comprise an RFID unit which can inductively be contacted by a control device out of the stamp. The RFID unit may be used to store information on e.g. the type of the stamp, the number of use cycles or the amount of thermal, pressure or strain stress the stamp has been exposed to. Using RFID devices, stamps could be recognizable for the imprinting, embossing or transfer system in which they are running.

The stamp may comprise at least three electrical contacts, whereof one may be used for power connection (also called VVC), one as data connection and one as common return part (often called ground or GND). The electrical contacts may have the form of a serial or parallel bus.

The properties of the stamp may change depending on position in a machine, on an imprinting substrate and/or according to data read from sensors comprised in the stamp.

The stamp may comprise a pixilated heating pad and may be heated depending on position under use.

The stamp may comprise a pixilated piezo element and may be actuated depending on position under use in order to e.g., create shockwaves or vibrations in a resin to promote the driving out of air bubbles.

The stamp may comprise a pixilated gripper array which may be actuated depending on the position under use.

The stamp may comprise a pixilated loadcell array and loadcell data may be adjusted depending on the position under use.

The stamp may comprise a pixilated light source and light emission e.g., for curing or detection purposes may be adjusted depending on the position under use.

The stamp may be powered and/or controlled via galvanic contacts. The contact with the source can be made for instance in the clamps which are used to also fix the stamp mechanically to a roller, a belt, a chuck or any other part of an imprinting, texturing or transferring device.

The stamp may be powered and/or controlled via a wire mounted on the galvanic contacts on the stamp.

The stamp may be powered and/or controlled via sliding contacts

The stamp may be powered and/or controlled via capacitive coupling e.g., in the clamp or on a roller.

The stamp may be powered and/or controlled via inductive coupling.

Powering and/or controlling via inductive and/or capacitive coupling is carried out via devices which are in the present application also understood to be "electrical contacts" although they are not in a direct material contact but only in contact through electrical and/or magnetic fields.

Any manner of powering may be controlled with any manner of controlling.

The stamp may comprise a battery.

The stamp may comprise a solar panel.

The stamp may comprise a device to electronically count process cycles.

The application further pertains to a wafer-scale, roll-to-roll or roll-to-plate imprint system comprising at least one means to hold a mold or stamp and means for electrical steering of the stamp in combination with printed, galvanic, capacitive and/or inductive electrical connection.

In an embodiment, the system according to the invention has the ability to steer the electrical current on the stamp. In this particular embodiment, the flexible stamp comprises electrical contacts which reach out of the flexible stamp and are connected to corresponding electrical contacts of the system. Said electrical contacts of the system are connected to an electrical power source which is either steerable by itself or within the connection between the power source and the electrical contacts of the system, a means for steering electrical power such as a potentiometer or transistor or any array or combination thereof is installed.

In an embodiment, steering is possible through a wire.

In an embodiment, steering is possible through adoptions in the manner the flexible stamp is mounted into the system. In this embodiment, the system may comprise several electric contacts providing electrical power in different voltages and/or electric current intensities.

In an embodiment, the electrical connection between the system and the flexible stamp is realized through sliding contacts such as carbon brushes or current collectors. The system may comprise contacts shaped like conductor rails while the flexible stamp comprises carbon brushes or current collectors similar to electric trains which make up an electrical connection between the system and the flexible stamp.

In an embodiment, the electrical connection between the system and the flexible stamp is formed using a capacitive or inductive connection or any combination thereof. For an inductive connection, the system comprises an inductivity e.g. in the form of an electrical coil as a transmitter and the flexible stamp comprises an inductivity e.g. in the form of an electrical coil as a receiver.

For a capacitive coupling, both the flexible stamp and the system may comprise two capacitor plates which may be combined in such a way that two capacitors are formed between the system and the flexible stamp. Application of a voltage between the two capacitor plates in the system may then lead to a current flow between the two capacitor plates in the flexible stamp via capacitive coupling.

Description of figures

The figures show embodiments of the subject matter of the present application, however the application is not limited to said embodiments.

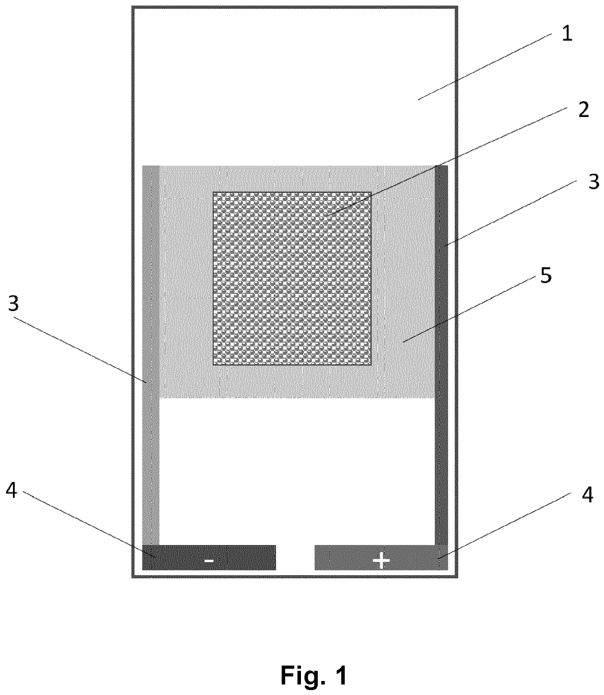

Fig. 1 shows a flexible stamp 1 comprising a textured area 2 which will be replicated into a layer of resin on a substrate. Furthermore, the flexible stamp 1 comprises two conductive tracks 3 which may be made of ITO or which may be printed wires as well as contact areas 4 which are connected to a source of electric energy. The flexible stamp 1 also comprises a uniform conductive area 5 fully behind the textured area which acts as a functional electrical component, here as an electric heating element.

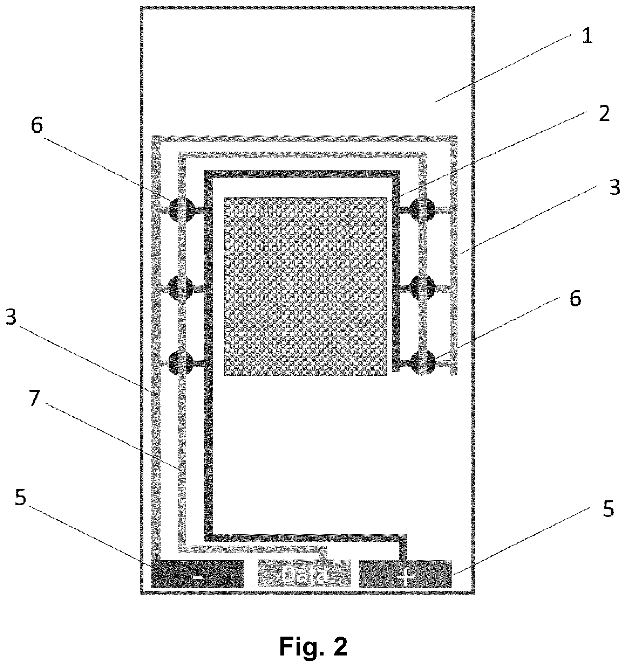

Fig. 2 shows a flexible stamp 1 comprising a textured area 2 which will be replicated into a layer of resin on a substrate. Furthermore, the flexible stamp 1 comprises two conductive tracks 3 which may be made of ITO or which may be printed wires as well as contact areas 4 which are connected to a source of electric energy. The conductive tracks 3 serve as energy supply. Furthermore, the flexible stamp 1 comprises another conductive track 7 which is used as data connection to sensors 6 which are pressure sensors in this example. Multiple pressure sensors 6 distributed over the flexible stamp 1 allow for measuring pressure at different positions on the stamp.

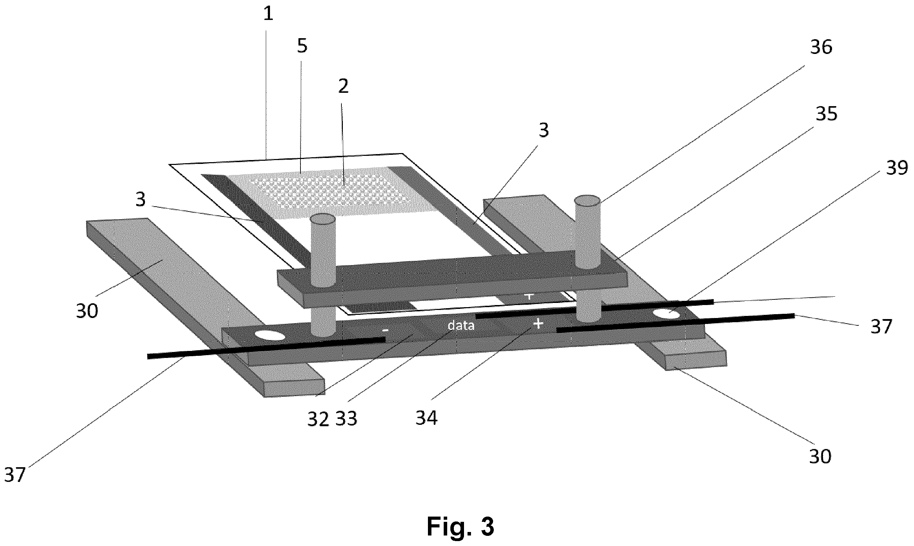

Fig. 3 shows the flexible stamp of Fig. 1 being mounted onto steering belts 30 using a clamp 31 to hold and electrically steer the flexible stamp 1. The clamp comprises electrical conducting contacts 32, 33 and 34 which are connected to corresponding contacts on the flexible stamp 1. The flexible stamp is fixed to the clamp 31 using a clamp lid 35 fixed to the clamp 31 using screws. The clamp 31 is mounted to the steering belt 30 using mounting points 39. Furthermore, the clamps comprise wires to an energy source and wires to a data source 38. Note that the flexible stamp 1 in this embodiment does not have an electrical data contact.

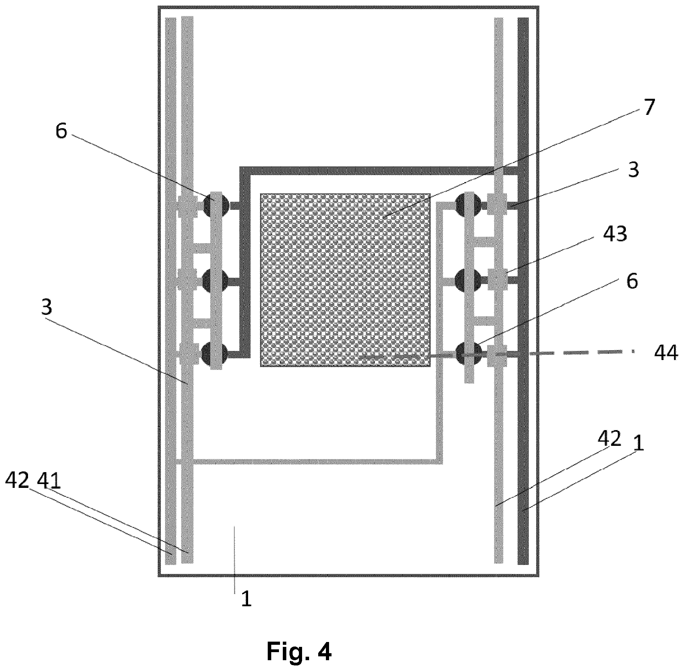

Fig. 4 shows an embodiment of the flexible stamp according to the present application similar to the one of Fig. 2. Also in this embodiment, the flexible stamp 1 comprises a textured area 2 which will be replicated into a layer of resin on a substrate. Furthermore, the flexible stamp 1 comprises two conductive tracks 3 which may be made of ITO or which may be printed wires as well as contact areas 4 which are connected to a source of electric energy. The conductive tracks 3 serve as energy supply. Furthermore, the flexible stamp 1 comprises another conductive track 7 which is used as data connection to sensors 6 which are pressure sensors in this example. Multiple pressure sensors 6 distributed over the flexible stamp 1 allow for measuring pressure at different positions on the stamp.

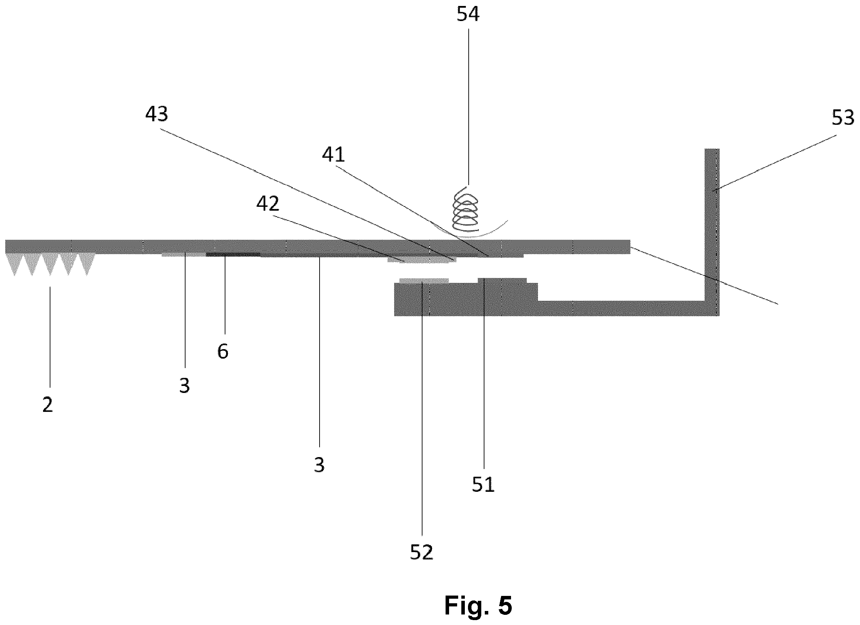

In contrast to the embodiment shown in Fig. 2, the conductive tracks are connected to sliding contact areas 41 for power supply and 42 as data connection. Insulating areas 43 prevent from contact between the two circuits for data and power supply. The dashed line 44 shows the axis along which the cross-cut of Fig. 5 is taken.

Fig. 5 shows a cross-cut of the flexible stamp of Fig. 4 along dashed line 44 wherein the flexible stamp 1 is shown which comprises a textured area 2 which will be replicated into a layer of resin on a substrate. Furthermore, the flexible stamp 1 comprises two conductive tracks 3 which may be made of ITO or which may be printed wires as well as a contact area for energy supply 41 and a contact area for data connection 42. The conductive tracks are connected to a sensor 6 and are separated from each other by an insulating area 43. The contact areas for energy supply is connected to a contact for energy supply 51 on a sliding rail 53 which is fixed to the imprint tool. The contact areas for data connection are connected to a contact for energy supply 52 on a sliding rail 53 which is fixed to the imprint tool. Contact between the contacts on the stamp and the contact areas on the sliding rail is assured by a spring 54 which presses the contacts against the sliding rail.

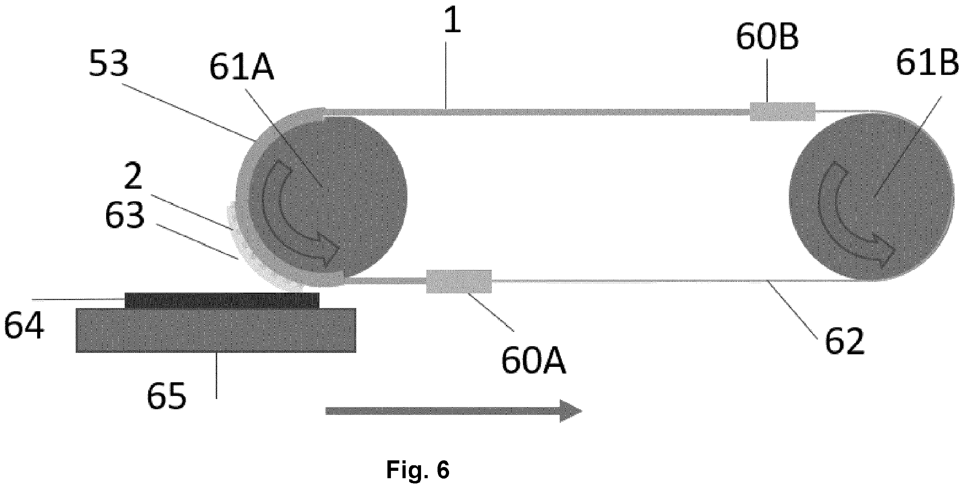

Fig. 6 shows a schematic view of a texturing process using an electrical flexible stamp 1 as shown in Figs. 4 and 5 is used to provide a substrate 64 with a layer of lacquer. In the process shown in Fig. 6 the textured area 2 of the flexible stamp 1 is covered by a layer of lacquer 63 and is contacted with the substrate 64 which is conveyed underneath the flexible stamp on a carrier 65. Note that the layer of lacquer 63 could also have been deposited on the substrate 64 instead of on the flex stamp 1, or at both. The flexible stamp 1 is fixed to a belt 62 using clamps 60A and 60B. The belt 62 and the flexible stamp are conducted by rollers 61A and 61B. In the proximity of roller 61A, the sliding rail 53 is mounted. The sliding rail 53 can contain the sliding contacts as shown in figure 4. The exact position of the sliding rail 53 can vary and is determined by the moment of contact point with the flexible stamp 1, enabling the electrical circuit to be electrical steered.

## Claims

1. Stamp for imprinting, texturing or transferring roll-to-roll, plate-to-roll and roll-to-plate processes comprising

   • a sheet of material as a carrier,
   • at least one surface,
   • an electrically conductive material,
   • at least two electrical contacts

2. The stamp in claim 1, where the carrier is flexible.

3. The stamp of any one or more of the previous claims wherein the stamp has a three-dimensional texture on at least one surface.

4. The stamp of any one or more of the previous claims wherein the electrically conductive material is as flexible as the carrier.

5. The stamp of any one or more of the previous claims wherein the electrically conductive material is essentially transparent for visible and/or near-ultraviolet light.

6. The stamp of claim 5 wherein the essentially transparent electrically conductive material is a doped metal oxide such as indium tin oxide (ITO), aluminum doped zinc oxide (AZO), indium doped zinc oxide (IZO) or gallium doped zinc oxide (GZO)

7. The stamp according to any one or more of the previous claims wherein the stamp further comprises an internal power supply unit such as a battery, a photovoltaic cell or an electromagnetic coil for inductive power transfer or any combination thereof.

8. The stamp of any one or more of the previous claims wherein the electrical contacts are galvanic, capacitive or inductive.

9. The stamp of any one or more of the previous claims wherein the electrical contacts are comprised in clamps which clamps allow for electrical attachment of the stamp to an imprinting, texturing or transferring apparatus.

10. The stamp of any one or more of the previous claims wherein the stamp comprises at least one functional electric component.

11. The stamp of claim 10 wherein at least one functional electric component is a functional electrical component such as heating pads, load cell arrays, gripper arrays, strain sensors, temperature sensors, piezo elements such as piezo actuators, light-emitting diodes, capacitors or any combination thereof.

12. The stamp of claim 10 or 11 wherein at least one functional electric component is a pixilated functional electrical component such as heating pads, load cell arrays, gripper arrays, strain sensors, temperature sensors, piezo elements such as piezo actuators, light-emitting diodes, pixilated capacitors or any combination thereof.

13. The stamp of any one or more of claims 10-12 wherein at least one functional electric component is an electric circuit.

14. The stamp of any one or more of claims 10-12 wherein at least one functional electric component is an RFID unit.

15. A wafer-scale, roll-to-roll or roll-to-plate imprint system comprising at least one means to hold a mold or stamp and means for electrical steering of the stamp in combination with printed, galvanic, capacitive and/or inductive electrical connection

**Fig. 1**

**Fig. 2**

**Fig. 3**

**Fig. 4**

**Fig. 5**

EP 4 307 048 A1

Fig. 6

**EP 4 307 048 A1**

Europäisches
Patentamt

European
Patent Office

Office européen
des brevets

# EUROPEAN SEARCH REPORT

Application Number

EP 22 18 4125

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/217822 A1 (CHOU STEPHEN Y [US] ET AL) 11 September 2008 (2008-09-11) | 1-6,15 | INV. G03F7/00 B81C1/00 |
| A | * paragraph [0018] * <br> * paragraphs [0028] - [0043]; figures 3a,5 * | 7-14 | |
| X | US 2015/352586 A1 (KIM SEOK [US] ET AL) 10 December 2015 (2015-12-10) | 1-6, 9-13,15 | |
| A | * paragraphs [0023] - [0039]; figures 1A-1H,3A,4A,4B * <br> * paragraph [0061] * | 7,8,14 | |
| X | CN 110 007 556 A (UNIV NANJING) 12 July 2019 (2019-07-12) <br><br> * paragraphs [0015] - [0017]; figure 1 * | 1,7,8, 10,11, 13-15 | |
| A | CN 2 842 969 Y (LI MAOJUN [CN]) 29 November 2006 (2006-11-29) * figures 1,2 * | 7,8,10, 14 | |
| A | US 2016/250875 A1 (TARNOWSKI CATHERINE P [US] ET AL) 1 September 2016 (2016-09-01) * paragraphs [0044] - [0049]; figure 1 * | 1,11,15 | TECHNICAL FIELDS SEARCHED (IPC) <br><br> G03F B82B B81C |

The present search report has been drawn up for all claims

| Place of search | Date of completion of the search | Examiner |
|---|---|---|
| Munich | 9 January 2023 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

2

## ANNEX TO THE EUROPEAN SEARCH REPORT
## ON EUROPEAN PATENT APPLICATION NO.

**EP 22 18 4125**

This annex lists the patent family members relating to the patent documents cited in the above-mentioned European search report.
The members are as contained in the European Patent Office EDP file on
The European Patent Office is in no way liable for these particulars which are merely given for the purpose of information.

**09-01-2023**

| Patent document cited in search report | | Publication date | Patent family member(s) | | Publication date |
|---|---|---|---|---|---|
| US 2008217822 | A1 | 11-09-2008 | NONE | | |
| US 2015352586 | A1 | 10-12-2015 | NONE | | |
| CN 110007556 | A | 12-07-2019 | NONE | | |
| CN 2842969 | Y | 29-11-2006 | NONE | | |
| US 2016250875 | A1 | 01-09-2016 | BR | 112016010214 A2 | 08-08-2017 |
| | | | CN | 105722687 A | 29-06-2016 |
| | | | EP | 3065951 A1 | 14-09-2016 |
| | | | KR | 20160082537 A | 08-07-2016 |
| | | | SG | 11201603375T A | 30-05-2016 |
| | | | TW | 201531413 A | 16-08-2015 |
| | | | US | 2016250875 A1 | 01-09-2016 |
| | | | WO | 2015069538 A1 | 14-05-2015 |

EPO FORM P0459

For more details about this annex : see Official Journal of the European Patent Office, No. 12/82